# EUROPÄISCHE PATENTANMELDUNG

(11) **EP 0 992 778 A2**
(43) Veröffentlichungstag der Anmeldung: **12.04.2000**
(21) Anmeldenummer: 99118506.7
(22) Anmeldetag: 18.09.1999
(51) Int. Cl.: G01L 9/06, G01L 9/12

(54) **Sensor und Verfahren zu seiner Herstellung**

(30) Priorität: 02.10.1998 DE 19845537
(71) Anmelder: GRUNDFOS A/S, DK-8850 Bjerringbro (DK)
(72) Erfinder: Eriksen, Gert Friis, 2670 Greve (DK)
(74) Vertreter: Vollmann, Heiko, Dipl.-Ing.

(57) **Zusammenfassung**

Das Verfahren dient zur Herstellung beispielsweise eines Drucksensors. Es wird zunächst eine erste Trägerschicht 1 mit einer das Messelement bildenden Schicht 3 versehen. Die das Messelement bildende Schicht 3 wird mit einer einen Abstand bildenden Schicht 4 überdeckt, die mindestens im Bereich des Messelementes eine Aussparung 5 aufweist. Dann wird eine zweite Trägerschicht 7 mit der den Abstand bildenden Schicht 4 verbunden, wonach die erste Trägerschicht 1 zur Bildung einer Membran ausgedünnt wird.

## Beschreibung

Die Erfindung betrifft ein Verfahren zur Herstellung eines Sensors sowie einen nach diesem Verfahren hergestellten Sensor, insbesondere einen Drucksensor oder Flowsensor.

Das Messen des Druckes oder Differenzdruckes in Fluiden zählt zu den wichtigsten Aufgaben bei der Überwachung technischer Anlagen. Heutzutage werden anstelle von Manometern in zunehmendem Maße Sensoren eingesetzt, die in Abhängigkeit des am Sensor anstehenden Druckes bzw. Differenzdruckes ein elektrisches Signal erzeugen bzw. modifizieren. Derartige Sensoren sind beispielsweise aus EP 0 548 470 A1 oder EP 0 801 293 A1 bekannt. Sie sind üblicherweise auf der Grundlage eines Siliziumträgers aufgebaut, der so dimensioniert ist, daß er die zu erwartenden mechanischen und hydraulischen Kräfte (Einspannkräfte, Druckkräfte etc.) aufnehmen kann. Auf diesem Siliziumträger ist ein elektrisches Messelement, beispielsweise ein piezoresistives Element oder auch ein Schichtwiderstand aufgebracht, wobei im Bereich dieses Messelementes der Siliziumträger in der Regel durch Ätzen zur Bildung einer Membran ausgedünnt ist.

Das Ausbilden dieser Membran wird fertigungstechnisch beherrscht, doch können sich Probleme ergeben. Die Schichtdicke im Bereich der Membran muß möglichst über die gesamte Membranfläche konstant sein und den vorgegebenen Werten von meist wenigen µm in engen Toleranzen entsprechen, da hierdurch das Auslenkverhalten bei Druckbeaufschlagung bestimmt wird. Ist die Membran zu dünn, besteht Bruchgefahr, ist sie zu dick, leidet hierunter die Messgenauigkeit bei geringen Drücken. Darüber hinaus besteht stets die Gefahr, daß bei Überschreiten eines bestimmten Druckes die Membran reißt und der Sensor damit unwiederbringlich zerstört wird. Darüber hinaus ist die stufenförmige Aussparung innerhalb des Trägers zur Bildung der Membran nachteilig im Hinblick auf das Aufbringen weiterer Schichten. So entstehen beispielsweise durch die Stufenstruktur beim Beschichten unerwünschte Kanteneffekte.

Vor diesem Hintergrund liegt der Erfindung die Aufgabe zugrunde, ein Verfahren zur Herstellung eines solchen Sensors zu vereinfachen, insbesondere zur Vermeidung der vorerwähnten Nachteile. Darüber hinaus soll mit diesem Verfahren ein Sensor geschaffen werden, der diese Nachteile bekannter Drucksensoren weitgehend vermeidet.

Der verfahrensmäßige Teil dieser Aufgabe wird durch die in Anspruch 1 angegebenen Merkmale gelöst. Der erfindungsgemäße Sensor ist durch die in Anspruch 11 angegebenen Merkmale gekennzeichnet. Vorteilhafte Ausgestaltungen des Verfahrens sowie des Sensors sind in den Unteransprüchen sowie der nachfolgenden Beschreibung angegeben.

Bei dem erfindungsgemäßen Verfahren wird zunächst eine bevorzugt aus einkristallinem Silizium bestehende Trägerschicht mit einem schichtförmigen Messelement versehen, wie dies auch bei bekannten Verfahren dieser Art bisher erfolgte. Dann jedoch wird im Gegensatz zu bekannten Verfahren nicht die Trägerschicht im Bereich des Messelementes ausgedünnt, sondern die das Messelement bildende Schicht mit einer weiteren Schicht versehen, die als abstandsbildende Schicht bezeichnet wird, da sie beim späteren Sensor den freien Abstand zwischen dem Messelement und der späteren eigentlichen Trägerschicht bestimmt. Diese abstandsbildende Schicht ist im Bereich des Messelementes ausgespart, so daß das Messelement von dieser Schicht nicht bedeckt wird. Sodann wird eine zweite Trägerschicht mit der den Abstand bildenden Schicht verbunden. Dann sind also die das Messelement bildende Schicht sowie die den Abstand bildende Schicht jeweils mit einer Trägerschicht versehen, die jede für sich ausreichende statische Stabilität geben, wie dies auch bei Trägerschichten gemäß dem einleitend genannten Stand der Technik außerhalb des Membranbereichs der Fall ist. Sodann wird die erste Trägerschicht zur Bildung einer Membran zumindest im Bereich des Messelementes ausgedünnt. Bevorzugt wird diese Trägerschicht jedoch ganzflächig ausgedünnt, um die eingangs beschriebenen nachteiligen Kanteneffekte beim weiteren Beschichten zu vermeiden.

Ein nach diesem Verfahrensprinzip hergestellter Drucksensor hat den Vorteil, daß das Messelement geschützt zwischen der ersten nunmehr ausgedünnten und die Membran bildenden Trägerschicht sowie der zweiten, die nunmehr die eigentliche Trägerschicht bildet, liegt. Diese Anordnung hat darüber hinaus den wesentlichen Vorteil, daß bei geeigneter Dimensionierung der den Abstand bildenden Schicht der Sensor weitgehend unempfindlich gegen Beaufschlagung mit unzulässig hohen, d. h. den Messbereich übersteigenden Drücken ist. Wenn nämlich die Membran mit dem darauf befindlichen Messelement, das in üblicher Weise als Messbrücke geschaltet ist, über den eigentlichen Messbereich hinaus ausgelenkt wird, so legt sich die Membran mit dem Messelement an die zweite Trägerschicht an, welche diese durch fluidischen Druck erzeugten mechanischen Kräfte ohne weiteres aufnimmt und ein Reißen der Membran und damit eine Zerstörung des Drucksensors verhindert.

In gleicher Weise kann nach dem erfindungsgemäßen Verfahren ein Flowsensor hergestellt werden, wobei dann das Messelement mindestens ein wärmeerzeugendes Bauteil sowie ein temperaturempfindliches Bauteil aufweist. Die Flussmessung erfolgt in an sich bekannter Weise in Abhängigkeit des Signals des Temperatursensors. In diesem Falle ist die Auslenkfunktion der Membran nicht erforderlich. hingegen eine gute Wärmeübertragung, was ebenfalls durch entsprechend dünne Schichtdicke erreicht wird.

Das erfindungsgemäße Fertigungsverfahren ermöglicht darüber hinaus eine vorteilhafte Kontaktierung des Messelementes, wie dies im folgenden noch im einzelnen ausgeführt werden wird. Wenn als Messelement ein resistives, beispielsweise ein piezoresistives Messelement eingesetzt werden soll, dann ist es erforderlich bei Verwendung von Siliziumschichten als Trägerschichten diese zunächst einmal zu isolieren, was beispielsweise durch Oberflächenoxidation erfolgen kann. Das Messelement kann dann in an sich bekannter Weise durch Aufbringen, Dotieren und Ätzen gebildet werden, derart, daß sich eine piezoresistive Schicht entsprechend der gewünschten Messelementeschaltungsanordnung ergibt.

Die auf die das Messelement bildende Schicht aufzubringende, den Abstand bildende Schicht wird bevorzugt elektrisch leitend ausgebildet, beispielsweise als ein- oder mehrkristalline Siliziumschicht, wobei im Bereich des eigentlichen Messelementes diese Schicht ausgespart ist. Darüber hinaus ergeben sich weitere Aussparungen, wenn diese Schicht, was zweckmäßig ist, leiterbahnartig ausgestaltet wird, da dann über diese abstandsbildende Schicht zugleich die elektrische Kontaktierung des Messelementes erfolgen kann. Eine solche Kontaktierung ist von besonderem Vorteil, da sie tief innerhalb des späteren Sensors geschützt durch beide Trägerschichten liegt.

Diese leiterbahnartigen Gebilde der Abstand bildenden Schicht werden später über Aussparungen in der zweiten Trägerschicht kontaktiert, wie dies beispielhaft in US-PS 4,261,086 beschrieben ist, auf die in diesem Zusammenhang verwiesen wird. Die Aussparungen können durch Ätzen im Maskenverfahren hergestellt werden. Um eine elektrische Leitung innerhalb dieser Aussparungen zu erreichen, werden diese nach dem Zusammenfügen mit den übrigen Teilen des Sensors mit einer metallischen Schicht versehen. Die zweite Trägerschicht wird also, wenn sie aus Silizium besteht, zunächst mit Aussparungen an den entsprechenden Stellen und dann mit einer isolierenden Oxidschicht versehen, wonach dann die abschnittsweise Metallisierung nach dem Fügen erfolgt. Die zweite Trägerschicht wird an der Seite, die zum Verbinden mit dem übrigen Schichtpaket vorgesehen ist, mit einer Glasschicht versehen. Die beiden Teile (erste Trägerschicht mit Messelement bildender Schicht und Abstand bildender Schicht sowie die zweite Trägerschicht mit der Glasschicht) werden dann in einem anodischen Bonding-Prozeß unter Fügedruck und Fügetemperatur bei entsprechender Haltezeit verbunden. Dabei bildet sich die verbindende Glasschicht nur in den Bereichen aus in denen die zweite Trägerschicht anliegt, also nicht im Bereich der Aussparungen, wo die spätere Kontaktierung erfolgen soll.

Wenn die beiden Trägerschichten unter Einschluß des Messelementes miteinander verbunden sind, dann erst wird die erste Trägerschicht ausgedünnt, und zwar vorteilhaft durch vollflächiges Ätzen bis auf Membranstärke. Die erste Trägerschicht, die dann keine Trägerschicht im eigentlichen Sinne mehr ist, weist im gesamten Bereich Membrandicke auf, so daß sich eine glatte und damit gleichmäßig und gut zu beschichtende Oberfläche ergibt. Die Unterseite des Sensors, also die Unterseite der zweiten Trägerschicht kann in gleicher Weise im wesentlichen glattflächig sein.

Um den Ätzvorgang präzise auf die gewünschte Schichtdicke hin steuern zu können, ist es zweckmäßig, in der ersten Trägerschicht eine den Ätzvorgang begrenzende Oxidschicht vorzusehen. Eine solche Oxidschicht kann ggf. durch Bondingprozesse hergestellt werden. Im übrigen sind Siliziumträger mit den Ätzvorgang begrenzenden Oxidschichten marktgängig.

Die zweite Trägerschicht kann auch vollständig aus Glas bestehen, wobei in jedem Falle die bereits vorbeschriebene abschnittsweise Metallisierung erfolgen muß, um die spätere Kontaktierung des Messelementes über die leiterbahnartig ausgebildeten Abschnitte der Abstand bildenden Schicht zu ermöglichen.

Um die Siliziummembran gegenüber dem Medium, dessen Druck bzw. Druckänderung oder dessen Flow mit dem Sensor zu messen ist, zu schützen, wird die gesamte, die Membran bildende Schicht vorteilhaft mit einer amorphen Metallschicht oder auch einer anderen Schutzschicht überdeckt. Da das Messelement, dessen elektrische Anschlüsse anders als beim Stand der Technik zwischen der Membran und der Trägerschicht angeordnet sind, auf der Innenseite der Membran liegt, kann das Aufbringen einer elektrisch isolierenden Schicht entfallen. Die amorphe Metallschicht kann direkt auf die Membran aufgebracht werden. Es sei in diesem Zusammenhang insbesondere auch auf EP 0 801 293 A1 verwiesen.

Die Erfindung ist nachfolgend anhand eines in der Zeichnung stark vereinfacht dargestellten Ausführungsbeispiels näher erläutert. Es zeigen
- Fig. 1: im Querschnitt ein auf einer ersten Trägerschicht aufgebautes Schichtpaket mit einem auf einer zweiten Trägerschicht aufgebautem Schichtpaket und
- Fig. 2: den aus den Sehichtpaketen nach dem Zusammenfügen gebildeten Drucksensor im Querschnitt.

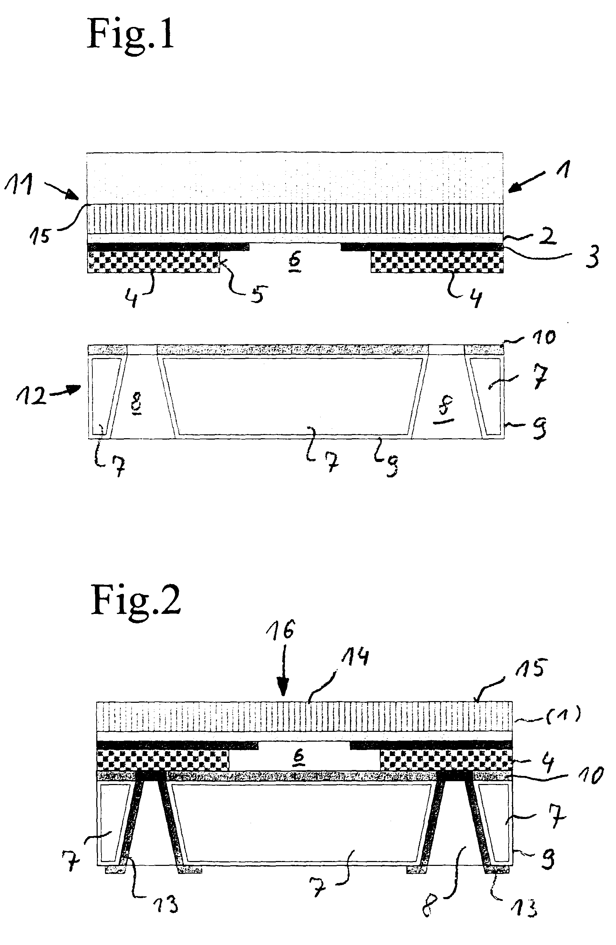

Der Aufbau des in Fig. 2 im Querschnitt schematisch dargestellten Drucksensors wird im folgenden beschrieben:

Eine erste aus einkristallinem Silizium bestehende Trägerschicht 1 wird einseitig mit einer Oxidschicht 2 versehen, was durch thermische Oxidation erfolgt. Diese Oxidschicht 2 dient ausschließlich zur elektrischen Isolierung gegenüber der leitenden Trägerschicht 1.

Auf die Oxidschicht 2 wird in an sich bekannter Weise eine, ein elektrisches Messelement bildende Schicht 3 aufgebracht. Unter Messelement im Sinne der vorliegenden Erfindung ist beispielsweise eine Anordnung von vier piezoresistiven Widerständen zu verstehen, die in üblicher Weise zu einer Brückenschaltung verschaltet sind. Hierzu kann ferner ein Kompensationswiderstand zur Temperaturkompensation der späteren Druckmessung zählen. Derartige Messelemente auf einer Siliziumträgerschicht aufzubringen zählt zum Stand der Technik und wird daher hier nicht im einzelnen beschrieben. Hierzu zählen beispielsweise auch kapazitive Messvorrichtungen.

Diese das eigentliche Messelement bildende Schicht 3 wird dann mit einer einen Abstand bildenden Schicht 4 versehen, die aus ein- oder mehrkristallinem Silizium besteht und elektrisch leitend ist. Die ein- oder mehrkristalline Siliziumschicht wird im CVD-Prozeß (Chemical Vapor Deposition) aufgebracht. Diese Schicht 4 ist dort, wo das eigentliche Messelement angeordnet ist, mit einer Aussparung 5 versehen, so daß das Messelement von dieser Abstand bildenden Schicht 4 nicht abgedeckt ist, sondern in dem dadurch gebildeten Freiraum 6 liegt. Die Abstand bildende Schicht 4 ist durch weitere, in der Zeichnung nicht sichtbare Freiräume in elektrisch zueinander durch Freiräume getrennte Abschnitte unterteilt, wie dies auch bei Leiterbahnen von gedruckten Schaltungen üblich ist, um diese elektrisch voneinander zu isolieren. Die Anordnung ist dabei so, daß über die Abstand bildende Schicht 4 das Messelement elektrisch kontaktiert wird.

Eine zweite, im vorliegenden Ausführungsbeispiel ebenfalls aus einkristallinem Silizium bestehende Trägerschicht 7 wird zunächst dort, wo eine Kontaktierung mit der Abstand bildenden Schicht 4 bzw. den dadurch gebildeten Leiterbahnen geplant ist, mit Aussparungen 8 versehen. Diese Aussparungen werden durch Ätzen in Maskentechnik hergestellt. Sodann wird die gesamte zweite Trägerschicht 7 mit einer Oxidschicht 9 versehen, danach die zweite Trägerschicht 7 einseitig mit einer Glasschicht 10 versehen.

Die nunmehr durch die erste Trägerschicht 1 und die zweite Trägerschicht 7 gehaltenen Schichtpakete 11 und 12 werden dann mit den in Fig. 1 zueinander gerichteten Seiten nach bestimmungsgemäßer Ausrichtung aufeinandergelegt, mit Druck beaufschlagt, erwärmt und eine gewisse Zeit gehalten, wonach die Bauteile 11 und 12 fest miteinander verbunden sind. Das Verbinden erfolgt in einem anodischen Bonding-Prozeß, der beispielsweise bei 250° bis 450° C bei einigen Minuten Haltezeit abläuft. Hiernach wird die zweite Trägerschicht 7 im Bereich der Aussparungen 8 durch Aufdampfen mit einer Metallschicht 13 versehen, die bis zu den entsprechenden Leiterbahnen der Abstand bildenden Schicht 4 reicht und leitend mit dieser verbunden ist. In diesen mit leitender Metallschicht versehenen Aussparungen 8 erfolgt dann die eigentliche Kontaktierung des späteren Drucksensors, in dem dort Drahtenden eingelötet oder eingeschweißt werden.

Nach Zusammenfügen der Schichtpakete 11 und 12 wird die erste Trägerschicht 1 durch Ätzen über ihre gesamte Fläche auf die Dicke einer Membran 14 ausgedünnt. Gleichwohl die Membranfunktion nur dort entsteht, wo der Freiraum 6 gebildet ist und das Messelement liegt, weist die erste Trägerschicht 1 über ihre gesamte Ausbreitung dieselbe Schichtdicke auf, so daß sich eine durchgehende glatte Fläche ergibt und das Messelement durch die Membran geschützt hinter dieser und vor der zweiten Trägerschicht 7 im Freiraum 6 liegt. Um den Ätzvorgang der ersten Trägerschicht 1 besser steuern zu können, ist in diese eine Zwischenschicht 15 eingebracht, welche den Ätzvorgang stoppt.

Die Stabilität dieses so gebildeten Sensors wird durch die zweite Trägerschicht 7 gewährleistet, die nunmehr die einzige Trägerschicht darstellt, da die erste Trägerschicht 1 zu einer Membran 14 ausgedünnt worden ist. Diese Membran 14 wird später aus Richtung 16 mit Druckmedium beaufschlagt. Zum Schutz vor dem Druckmedium wird die Membran 14 an der Außenseite mit einer amorphen Metallschicht versehen, wie sie aus EP 0 801 293 A1 bekannt ist. Dadurch, daß die Oberfläche der Membran 14 vollkommen eben und glatt ist, können die nachfolgenden Beschichtungen über die gesamte Fläche mit gleichbleibender Schichtdicke aufgetragen werden.

Der vorstehend beschriebene Drucksensor ist zur einseitigen Druckbeaufschlagung aus Richtung 16 vorgesehen. Wenn hieraus ein Differenzdrucksensor gebildet werden soll, so können zwei derartige Sensoren nebeneinanderliegend angeordnet werden, wobei diese im selben Herstellungsprozeß auf denselben Trägerschichten 1 und 7 aufgebaut werden. Es handelt sich dann praktisch um zwei unabhängig voneinander arbeitende Drucksensoren. Alternativ können auch zwei der erfindungsgemäßen Drucksensoren mit ihren Rückseiten aneinandergesetzt werden. wobei dann die Verdrahtung zwischen den Sensoren erfolgt.

Die sich aus den Figuren 1 und 2 ergebenden Schichtdicken entsprechen nicht den tatsächlichen, sondern dienen ausschließlich zur Erläuterung des Aufbaus. Die Schichtdicken eines solchen Drucksensors können beispielsweise folgende Abmessungen haben:

| | |
|---|---|
| Membran 14 | 20 µm |
| piezoresistive Schicht 3 | 0,5 µm |
| Abstand bildende Schicht 4 | 1,5 bis 2 µm |
| Glasschicht 10 | 5 µm |
| Zweite Trägerschicht 7 | 500 µm |

Die Dicke der Abstand bildenden Schicht 4 ist so gewählt, daß die Membran 14 bei Fluidbeaufschlagung mit einem über dem Messbereich des Messelementes liegenden Druck nicht zerstört wird, sondern sich an der zweiten Trägerschicht 7 über die dazwischen liegende Glasschicht 10 abstützt. Die Trägerschicht 7 bildet somit einen Anschlag für die Membran und verhindert weitgehend die Zerstörung des Sensors bei zu hoher Druckbeaufschlagung.

Die Erfindung wurde vorstehend anhand eines Drucksensors beispielhaft beschrieben. In analoger Weise können auch andere Sensoren, beispielsweise Flowsensoren aufgebaut werden. Ein Flowsensor würde sich von dem anhand der Figuren 1 und 2 beschriebenen Aufbau nur in der das Messelement bildenden Schicht 3 unterscheiden. Diese wird zwar prinzipiell in gleicher Weise aufgebaut, jedoch wird anstelle der beim Drucksensor in der Regel zu einer Brücke verschalteten piezoresistiven Widerstände in Verbindung mit einem Temperaturkompensationswiderstand ein wärmeerzeugendes Bauelement sowie ein temperaturempfindlicher Widerstand oder anderes temperaturempfindliches Bauelement eingebracht ist, wie dies bei nach dem Anemometerprinzip arbeitenden Flowsensoren an sich bekannt ist. Auch hier liegen die elektronischen Bauteile des Sensors geschützt zwischen Trägerschicht und Membran, wobei die Membran lediglich die Aufgabe hat, einen möglichst direkten Wärmeübergang zu schaffen. Der durch die Aussparung in der Abstand bildenden Schicht geschaffene Freiraum dient zur thermischen Isolation des wärmeerzeugenden Elementes sowie des temperaturempfindlichen Elementes gegenüber dem übrigen Sensor.

### Bezugszeichenliste

- 1: - Erste Trägerschicht
- 2: - Oxidschicht
- 3: - Messelement bildende Schicht
- 4: - Abstand bildende Schicht
- 5: - Aussparung
- 6: - Freiraum
- 7: - Zweite Trägerschicht
- 8: - Aussparungen
- 9: - Oxidschicht
- 10: - Glasschicht
- 11: - Oberes Schichtpaket in Fig. 1
- 12: - Unteres Schichtpaket in Fig. 1
- 13: - Metallschicht
- 14: - Membran
- 15: - Zwischenschicht
- 16: - Richtung

## Patentansprüche

1. Verfahren zur Herstellung eines Sensors mit folgenden nacheinander auszuführenden Verfahrensschritten:
- auf eine erste Trägerschicht (1) wird ein Messelement in Form einer Schicht (3) aufgebracht,
- die das Messelement bildende Schicht (3) wird mit einer einen Abstand bildenden Schicht (4) versehen, die mindestens im Bereich des Messelementes eine Aussparung (5) aufweist,
- eine zweite Trägerschicht (7) wird mit der den Abstand bildenden Schicht (4) verbunden und
- die erste Trägerschicht (1) wird zur Bildung einer Membran (14) zumindest im Bereich des Messelementes ausgedünnt.

2. Verfahren nach Anspruch 1, dadurch gekennzeichnet, daß als Trägerschichten (1, 7) Siliziumschichten verwendet werden, die vorzugsweise oberflächenoxidiert sind.

3. Verfahren nach einem der vorhergehenden Ansprüche, dadurch gekennzeichnet, daß die das Messelement bildende Schicht (3) eine in die Trägerschicht (1) dotierte piezoresistive Schicht ist.

4. Verfahren nach einem der vorhergehenden Ansprüche, dadurch gekennzeichnet, daß die den Abstand bildende Schicht (4) elektrisch leitend und zur Kontaktierung des Messelementes leiterbahnartig ausgestaltet wird.

5. Verfahren nach einem der vorhergehenden Ansprüche, dadurch gekennzeichnet, daß die den Abstand bildende Schicht (4) als ein- oder mehrkristalline Siliziumschicht ausgebildet wird.

6. Verfahren nach einem der vorhergehenden Ansprüche, dadurch gekennzeichnet, daß die zweite Trägerschicht (7) mit Aussparungen (8) versehen wird, die zur Kontaktierung der darunter angeordneten Abstand bildenden Schicht (4) dienen.

7. Verfahren nach einem der vorhergehenden Ansprüche, dadurch gekennzeichnet, daß die zweite Trägerschicht (7) zumindest abschnittsweise metallisiert wird.

8. Verfahren nach einem der vorhergehenden Ansprüche, dadurch gekennzeichnet, daß die erste Trägerschicht (1) nach dem Verbinden mit der zweiten Trägerschicht (7) vorzugsweise vollflächig durch Ätzen ausgedünnt wird.

9. Verfahren nach einem der vorhergehenden Ansprüche, dadurch gekennzeichnet, daß innerhalb der ersten Trägerschicht (1) eine den Ätzvorgang begrenzende Zwischenschicht (15) vorgesehen wird.

10. Verfahren nach einem der vorhergehenden Ansprüche, dadurch gekennzeichnet, daß das Verbinden der zweiten Trägerschicht (7) mit der Abstand bildenden Schicht (4) durch einen anodischen Bondingprozeß erfolgt.

11. Sensor mit einer Trägerschicht (7) und einer ein Messelement aufnehmenden Membran (14), dadurch gekennzeichnet, daß zwischen Trägerschicht (7) und Membran (14) eine die Membran mit Abstand zur Trägerschicht (7) haltende Schicht (4) vorgesehen ist, welche mindestens im Bereich des Messelementes eine Aussparung (5) aufweist.

12. Sensor nach Anspruch 11, dadurch gekennzeichnet, daß der Sensor ein Drucksensor ist und daß die Membran (14) bei Druckbeaufschlagung von außen zusammen mit dem Messelement zur Trägerschicht (7) hin auslenkbar ist.

13. Sensor nach Anspruch 11, dadurch gekennzeichnet, daß der Sensor ein Flowsensor ist.

14. Sensor nach Anspruch 13, dadurch gekennzeichnet, daß die das Messelement bildende Schicht auch ein Element zur Wärmeerzeugung aufweist.

15. Sensor nach einem der vorhergehenden Ansprüche, dadurch gekennzeichnet, daß die Trägerschicht (7) und/oder die Membran (14) aus einkristallinem Silizium gebildet sind.

16. Sensor nach einem der vorhergehenden Ansprüche, dadurch gekennzeichnet, daß die Trägerschicht (7) aus Glas besteht.

17. Sensor nach einem der vorhergehenden Ansprüche, dadurch gekennzeichnet, daß die Trägerschicht (7) bzw. die ggf. darauf aufgebrachte Bindeschicht (10) einen Anschlag für die Membran (14) bildet.

18. Sensor nach einem der vorhergehenden Ansprüche, dadurch gekennzeichnet, daß die Trägerschicht (7) mittels einer Glasschicht (10) mit der den Abstand bildenden Schicht (4) verbunden ist.

19. Sensor nach einem der vorhergehenden Ansprüche, dadurch gekennzeichnet, daß die den Abstand bildende Schicht (4) elektrisch leitend und zur Kontaktierung des Messelementes leiterbahnartig ausgebildet ist.

20. Sensor nach einem der vorhergehenden Ansprüche, dadurch gekennzeichnet, daß die den Abstand bildende Schicht (4) aus ein- oder mehrkristallinem Silizium besteht.

21. Sensor nach einem der vorhergehenden Ansprüche, dadurch gekennzeichnet, daß die Trägerschicht (7) Aussparungen (5) aufweist, durch welche die Kontaktierung des Messelementes erfolgt.

22. Sensor nach einem der vorhergehenden Ansprüche, dadurch gekennzeichnet, daß die Trägerschicht (7) zumindest abschnittweise metallisiert ist.

23. Sensor nach einem der vorhergehenden Ansprüche, dadurch gekennzeichnet, daß die Membran (14) an ihrer Außenseite mit einer Schutzschicht versehen ist, vorzugsweise aus Chrom-Tantal oder Siliziumkarbid.

24. Sensor, dadurch gekennzeichnet, daß zwei Drucksensoren nach einem der vorhergehenden Ansprüche zur Bildung eines Differenzdrucksensors nebeneinander auf derselben Trägerschicht angeordnet sind.

25. Sensor, dadurch gekennzeichnet, daß zwei Drucksensoren nach einem der vorhergehenden Ansprüche zur Bildung eines Differenzdrucksensors mit ihren Trägerschichten aneinander anliegend angeordnet sind.
